# EUROPEAN PATENT SPECIFICATION

(11) **EP 2 675 943 B1**
(45) Date of publication and mention of the grant of the patent: **08.04.2015**
(21) Application number: 12710550.0
(22) Date of filing: 14.02.2012
(51) Int. Cl.: C30B 1/02, C04B 35/628, C04B 41/85

(54) **A PROCESS FOR DEVELOPING A COMPOSITE COATING OF DIAMOND LIKE CARBON AND GRAPHITE ON SILICON CARBIDE GRAIN BY INDIRECT ARC PLASMA HEATING DISSOCIATION**
VERFAHREN ZUR ENTWICKLUNG EINES VERBUNDBESCHICHTUNG AUS DIAMANTARTIGEM KOHLENSTOFF UND GRAPHIT AUF SILIZIUMKARBIDKÖRNERN DURCH INDIREKTE LICHTBOGENPLASMA-WÄRMEDISSOZIATION
PROCÉDÉ POUR DÉVELOPPER UN REVÊTEMENT COMPOSITE DE CARBONE DE TYPE DIAMANT ET DE GRAPHITE SUR UN GRAIN DE CARBURE DE SILICIUM PAR DISSOCIATION PAR CHAUFFAGE À L'ARC PLASMA INDIRECT

(30) Priority: 14.02.2011 IN DE03602011
(43) Date of publication of application: 25.12.2013
(73) Proprietor: Council of Scientific & Industrial Research, New Delhi 110 001 (IN)
(72) Inventor: NAYAK, Bijan, Bihari, Bhubaneswar 751 013 Orissa (IN)
(74) Representative: Kador & Partner
(86) International application number: PCT/IB2012/050655
(87) International publication number: WO 2012/110944

(56) References cited:
- JP-A- 7 232 978
- DATABASE INSPEC [Online] THE INSTITUTION OF ELECTRICAL ENGINEERS, STEVENAGE, GB; April 2004 (2004-04), NAYAK B B: "In situ deposition of multiphase carbon composite coating on SiC grains through thermal plasma dissociation of SiC", XP002676649, Database accession no. 8147185 cited in the application -& NAYAK B B: SURFACE ENGINEERING, vol. 20, no. 2, 1 April 2004 (2004-04-01), pages 139-142, XP002676650, ISSN: 0267-0844, DOI: 10.1179/026708404225014906
- DATABASE WPI Week 200838 Thomson Scientific, London, GB; AN 2008-F99749 XP002676659, -& KR 2007 0106105 A (LEE H J) 1 November 2007 (2007-11-01)
- NAYAK B B: "SiC/C nanocable structure produced in silicon carbide by arc plasma heating", APPLIED PHYSICS A; MATERIALS SCIENCE & PROCESSING, SPRINGER, BERLIN, DE, vol. 106, no. 1, 10 September 2011 (2011-09-10), pages 99-104, XP019993054, ISSN: 1432-0630, DOI: 10.1007/S00339-011-6565-Z cited in the application
- DATABASE WPI Week 200649 Thomson Scientific, London, GB; AN 2006-473990 XP002677172, & IN DEL 200400472 A1 (COUNCIL SCI & IND RES INDIA) 26 May 2006 (2006-05-26) cited in the application

## Description

### FIELD OF THE INVENTION

The present invention relates to a process for in situ growth of carbonaceous composite coating on silicon carbide (SiC) grains by thermal dissociation of SiC by indirect arc plasma heating. More particularly, the present invention relates to a process for *in situ* growth of carbonaceous composite coating having diamond like carbon (DLC) and graphite on silicon carbide grain by thermal dissociation of SiC by indirect arc plasma heating. Further, the present invention relates to modified arc plasma which provides an indirect heating of SiC (charge or material). Further, the present invention also relates to high temperature dissociation of silicon carbide (SiC) and selected removal of silicon from silicon carbide grain surface.

### BACKGROUND OF THE INVENTION

The mono carbide of silicon (SiC) exhibits non-melting property. It directly dissociates into Si and C above 2200°C and the process completes at 2825°C. Dissociation of high temperature withstanding carbides by thermal method is generally done by heating carbide compounds to required temperatures in electrically heated furnace but going for heating above 1800°C usually poses difficulty. Graphite furnaces and arc furnaces are used to attain temperature above 2000°C. While graphite furnace requires graphite tube or granule heating for several hours before reaching the desired temperature, arc furnace on the other hand is difficult to control selected temperature and that too the furnaces are mostly available for large scale processing. More over, arc furnace uses air medium which is not independent of oxidation potential.

Arc plasma heating, as an alternative method, does not suffer from the demerits as occur in case of arc furnace where inert gas like argon (Ar) is used to form plasma between anode and cathode. This kind of plasma heating is also an instantaneous method which can produce temperature up to 10,000°C under laboratory conditions. In spite of such advantages, the notable shortcoming of arc plasma heating includes difficulty in placement of charge (material under processing) in the limited space available between anode and cathode and their vicinity. Thus, plasma flame directly hits upon the charge/material (its grains) and interferes in the physical and chemical processing. Secondly, uniform heating of charge is not possible due to existence of several varying temperature zones in arc region of plasma.

Journal Nature, vol 193,1962, page 569-570, wherein the conversion of α SiC (6H) to graphite by heating in vacuo is reported.

Journal Ognepory, No. 8, August 1967, page 44-50, Translated and reported in Refr. Industr. Ceram., vol. 8, No. 7-8, page 499-504, DOI: 10.1007/BF01284829, wherein the thermodynamic analysis of dissociative volatilization of silicon carbide in the temperature range 2500-3150K is reported and the composition of equilibrium gaseous phase over silicon carbide and the degree of progress of reactions of dissociation and volatilization of SiC have been established.

Journal Jpn. J. Appl. Phys. Vol 30, 1991, page 545-553, wherein the stability of 3C-SiC in the temperature range 1800-2400°C (in Argon atmosphere) has been investigated and a solid state phase transformation from 3C-SiC to 6H-SiC above 2150°C is reported.

Journal Appl. Phys. Lett, vol. 71, 1997, page 2620-2622, wherein the sublimation decomposition of silicon carbide at 1700°C using YAG laser heating in a transmission electron microscope (TEM) was studied by Kusunoki, Rokkaku and Suzuki. They observed growth of carbon nanotube (CNT) oriented along [111] direction on the (111) surface plane of β-SiC single crystal.

Journal Nature, vol. 411, 2001, page 283-286, relates to Si extraction from SiC by reacting a toxic gas like chlorine with SiC at high temperature (1000°C) for a time between 30 min to 30 hours. The drawback of the prior art is the use of toxic halogen gas, relatively long reaction time and slow reaction kinetics.

Journal Surf. Engg., vol. 20, 2004, page 139-142, wherein direct exposure of SiC powder to Ar arc plasma for 15-30 min followed by cooling exhibits small XRD peaks corresponding to several phases of carbon that include diamond, lonsdaleite, DLC and graphite.

Stiver of University of Massachussets, USA (The 2009 NNIN Research Accomplishments, page 164-165) discloses a epitaxial layer of graphene (two dimensional thin graphite lattice) has been grown by thermal decomposition of silicon (Si) terminated 4H-Si(0001) in ultra high vacuum (UHV) at a temperature 1150-1600°C. The shortcoming of the prior art process is that it uses expensive and sophisticated process like UHV and produces graphene layer only. No DLC is produced by the process as disclosed in the present application. Hence the dual advantages of high hardness and lubricating property of a layer cannot be derived from the disclosed process of the prior art.

US 5,756,061, patent describes a process involving heating a mixture of SiC with oxides like MgO, FeO, CaO, BaO, etc. at high temperature (up to 1200°C) and high pressure (5-6 GPa) for two days and then cooling the mixture to ambient temperature while under pressure. The carbon in the solid matrix converts to diamond phase and is isolated from other associated materials by adoption of standard physical methods.

US 2001047980 patent application describes a process for the synthesis of carbon coating on the surface of metal carbides, preferably SiC, by etching in halogen containing gaseous etchant, and optionally hydrogen gas, leading to the formation of a carbon layer on the metal carbide. The temperature of etching by halogen (CI) is between 600-1100 °C and the time taken is between 30 minutes to 30 hours in case of SiC. Flowing gas mixture of 1-3.5% C12, 0-2%H2 and balance Ar was used.

US 7,241,475, patent describes a method for producing carbon surface films on titanium carbide by exposure to radio frequency plasma using halogen gases and it claims the process to be generic and applicable to silicon carbide, tungsten carbide, etc.

US 7,678,452 and US 7,744,843, describes the decomposition /dissociation of various carbides including silicon carbide by treatment with halogen to produce carbon nanotubes(CNT).

IN 238049, patent discloses a only a diamond like carbon (DLC) coating prepared by directly exposing silicon carbide (SiC) powder to arc plasma flame produced within the graphite crucible. The DLC coating is characterized by higher hardness and therefore more brittle. However, in the present invention composite coating of DLC + graphite is deposited by indirect arc plasma. Major drawback of the prior art is that it did not address the issue of uniform heating of charge, interference of plasma flame in the *in situ* film/coating growth process and mixing of impurities emanated from electrode with charge in the arc plasma heating.

In order to overcome these difficulties faced in direct arc plasma heating, an indirect arc plasma heating process has been developed which produces uniform heating in a crucible to dissociate high temperature carbide compound like SiC and removes Si atoms from SiC grain surface. The limitation of inter-electrode spacing causing restriction in charge throughput (in direct arc plasma heating) does not arise in the indirect heating process. If SiC is treated in an indirect arc plasma heated reactor/furnace at a temperature above the boiling point of Si (2680°C), Si will dissociate and vaporize from SiC grain. The left out C will produce/develop a composite layer of DLC and graphite on the grain *in situ* when plasma heating will be switched off and the grain shall be allowed to cool to lower temperatures below 2200°C. The graphite and DLC (diamond like carbon) composite has a good scope for application as grinding and polishing medium/compound (for of metals, ceramics, leathers, marbles, etc.), for use in dynamic seals of water pumps and brake pads, etc., where both good lubricating property as well as higher hardness value are desirable at the same time. As a process, the indirect arc plasma heating dissociation is also applicable to other types of compounds (e.g. B₄C) which do not undergo melting but directly dissociate under thermal heating.

The above mentioned prior art reports basic investigations involving graphite formation from SiC and in some of the prior art polluting gases like halogens are used in high temperature etching to dissociate SiC. Halogen gases are toxic and chlorine is known to be responsible for ozone hole creation.

No work has so far been reported on the deposition of a composite coating of DLC and graphite on SiC grain using indirect arc plasma heating. The composite layer characterized by both improved hardness (wear resistance property) due to DLC and lubricating property due to graphite finds industrial applications in grinding, polishing and lapping of metals, ceramics, leather, and in the making of water pump seal, braking pad, etc.

An advantage of the present invention of composite coating over the prior art is the combination of hard DLC and soft graphite composite coating that overcomes peeling off behavior of the coating on SiC surface.

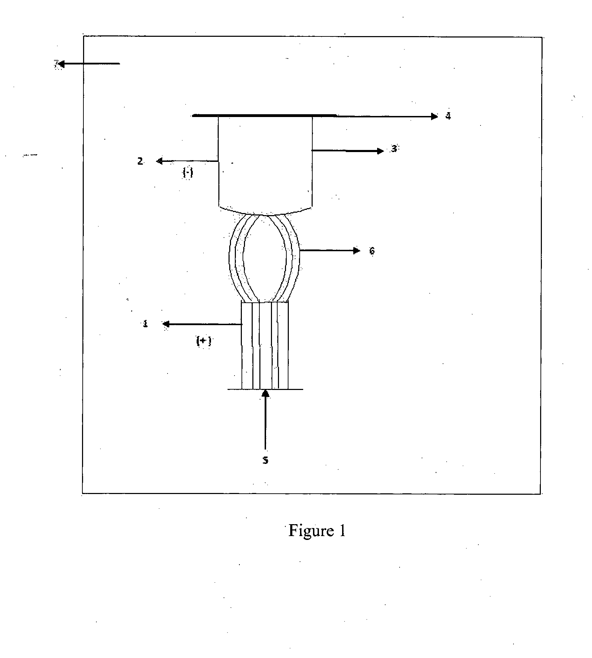

The novelty of the invented process lies in the idea that a single step process is employed where a conducting ceramic crucible (e.g graphite crucible) is configured in a special manner so as to serve as the cathode while being heated up from its bottom by plasma flame during arc discharge (**Fig.1**). SiC grains placed within the crucible, thus get uniformly heated unlike as in conventional direct arc plasma heating process. Secondly, SiC grains directly do not get exposed to the plasma flame produced in the arc, the flame hits upon the base wall of the crucible only. Hence, impurities released from anode/electrode do not get any chance to mix with the charge (SiC) kept inside the crucible during processing operation. Thirdly, the plasma flame does not get any scope to disturb (physically) the epitaxial growth (a slow process) of carbon on SiC nucleus because the crucible wall including base wall stands as a barrier of separation between SiC grains and plasma flame, thus the process improves the possibility of more DLC and graphite formation. The innovativeness of the process lies in the non-use of hydrocarbon and hydrogen gas in the growth of DLC + graphite coating unlike in the existing processes.

The non-obviousness of the process involves the high temperature (2900-3100°C) produced in arc plasma which is able to cause complete dissociation and selective removal and vaporization of Si atoms as 2680°C (Boiling Point of silicon). Also, use of inert gas/Ar as plasma forming gas and circulation of inert gas/Ar in the crucible and reactor/furnace prevents oxidation of SiC, DLC, graphite, Si and C.

### OBJECTIVE OF THE INVENTION

The main object of the present invention is to provide a process for in situ growth of carbonaceous composite coating on silicon carbide (SiC) grains by thermal dissociation of SiC by indirect arc plasma heating.

Another objective of the present invention is to provide a process for *in situ* growth of carbonaceous composite coating having diamond like carbon (DLC) and graphite on silicon carbide grains by thermal dissociation of SiC by indirect arc plasma heating. Yet another object of the present invention is to provide a process for high temperature dissociation of silicon carbide (SiC) and selected removal of silicon from silicon carbide grain surface.

Yet another object of the present invention is providing a process for dissociation of non-melting type high temperature carbides and other compounds including silicon carbide.

### SUMMARY OF THE INVENTION

Accordingly, the present invention provides a process for in situ growth of carbonaceous composite coating of diamond like carbon (DLC) and graphite on silicon carbide (SiC) grains by carrying out thermal dissociation of SiC by an indirect arc plasma heating and the said process comprising the steps of (i) providing SiC grains in a graphite crucible; (ii) passing inert gas in the arc zone situated below the graphite crucible at the rate of 3 to 15 litre per minute to produce high temperature in the range of 2900 to 3100°C; (iii) passing inert gas inside the graphite crucible at the rate of 1 to 3 litre per minute; (iv) heating the graphite crucible by arc plasma for a period in the range of 15 to 30 minutes maintaining arc length in the range of 1 to 3 cm, voltage in the range of 50 to 70 V and current in the range of 400 to 550A; (v) continuing the inert gas flow in arc zone and in graphite crucible for 50 to 70 minutes; (vi) cooling the reactor for a period in the range of 3 to 5 hours until temperature reaches in the range of 25 to 30°C to obtain a carbonaceous composite coating having diamond like carbon and graphite on silicon carbide (SiC) grains. Further, the present invention relates to a process for high temperature dissociation of silicon carbide (SiC) and selected removal of silicon from silicon carbide grain surface.

### BRIEF DESCRIPTION OF THE DRAWINGS

Figure 1 represents schematic view of indirectly heated arc plasma reactor.
Figure 2 represents micro Raman spectra of composite coated SiC grains of example 1.
Figure 3 represents micro Raman spectra of composite coated SiC grains of example 2.
Figure 4 represents micro Raman spectra of composite coated SiC grains of example 3.
Figure 5 represents micro Raman spectra of composite coated SiC grains of example 4.

### DETAILED DESCRIPTION OF THE INVENTION

While the invention is susceptible to various modifications and alternative forms, specific aspect thereof has been shown by way of example and graphs and will be described in detail below. It should be understood, however that it is not intended to limit the invention to the particular forms disclosed, but on the contrary, the invention is to cover all modifications, equivalents, and alternative falling within the spirit and the scope of the invention as defined by the appended claims.

The Applicants would like to mention that the examples are mentioned to show only those specific details that are pertinent to understanding the aspects of the present invention so as not to obscure the disclosure with details that will be readily apparent to those of ordinary skill in the art having benefit of the description herein.

The terms "comprises", "comprising", or any other variations thereof, are intended to cover a non-exclusive inclusion, such that a process, that comprises a list of components does not include only those components but may include other components not expressly listed or inherent to such process.

In the following detailed description of the aspects of the invention, reference is made to the accompanying drawings and graphs that form part hereof and in which are shown by way of illustration specific aspects in which the invention may be practiced. The aspects are described in sufficient details to enable those skilled in the art to practice the invention, and it is to be understood that other aspects may be utilized and that charges may be made without departing from the scope of the present invention. The following description is, therefore, not to be taken in a limiting sense, and the scope of the present invention is defined only by the appended claims.

Accordingly, the present invention relates to a process for in situ growth of carbonaceous composite coating of diamond like carbon (DLC) and graphite on silicon carbide (SiC) grains by carrying out thermal dissociation of SiC by an indirect arc plasma heating and the said process comprising the steps of: (i) providing SiC grains in a graphite crucible; (ii) passing inert gas in the arc zone situated below the graphite crucible at the rate of 3 to 15 litre per minute to produce high temperature in the range of 2900 to 3100°C; (iii) passing inert gas inside the graphite crucible at the rate of 1 to 3 litre per minute; (iv) heating the graphite crucible by arc plasma for a period in the range of 15 to 30 minutes maintaining arc length in the range of 1 to 3 cm, voltage in the range of 50 to 70 V and current in the range of 400 to 550A; (v) continuing the inert gas flow in arc zone and in graphite crucible for 50 to 70 minutes; (vi) cooling the reactor for a period in the range of 3 to 5 hours until temperature reaches in the range of 25 to 30°C to obtain a carbonaceous composite coating comprising diamond like carbon and graphite on silicon carbide (SiC) grains.

In another aspect of the invention in step (ii) inert gas in the arc zone is passed through a central axial hole in the graphite anode.
In another aspect of the invention, SiC grains used are selected from the group consisting of coarse, fine, ultrafine, nano crystalline or lumps or combination thereof.

In another aspect of the invention, inert gas used in step (ii) is argon.

In another aspect of the invention, inert gas used in step (iii) is selected from the group consisting of Ar, N₂ or their mixture with H₂ in the ratio ranging 1:1 to 1:3.

In another aspect of the present invention high temperature dissociation of silicon carbide (SiC) and selected removal of silicon from silicon carbide grain surface is carried out.

In another aspect of the invention, silicon is selectively removed from the surface of SiC grains to the extent of 98-99 %.

In another aspect of the invention, recovery percentage of heat treated SiC grains is in the range of 98 to 99%.

In another aspect of the invention, the process achieves a carbonaceous composite layer of DLC and graphite on SiC grain surface with 98 to 99 at % carbon.

In another aspect of the invention, diamond like carbon and graphite composite coated silicon carbide (SiC) grains are useful in grinding, polishing, lapping of surfaces of metals, marbles, granite, leather, in the making of water pump seals and brake pads.

In another aspect of the invention, diamond like carbon (DLC) + graphite composite coated silicon carbide (SiC) grains exhibit hardness in the range of 1900-2600 VHN 0.1 due to presence of DLC.

In another aspect of the invention diamond like carbon + graphite composite coated silicon carbide (SiC) grains exhibit lubricating property due to the presence of graphite.
In another aspect of the invention, the micro Raman spectra peaks of the composite on SiC grains are observed in the range 1335-1368 cm⁻¹ due to DLC and at 1569-1596 cm⁻¹ & 2677-2730 cm⁻¹ due to graphite.

In another aspect of the invention, said process is useful for all non-melting compounds including the carbides which dissociate on heating for producing coatings of different kinds including DLC and graphite.

In another aspect of the invention, said process leads to an *in situ* composite coating endowed with higher hardness as well as good lubricating property.

In another aspect of the invention, said process leads to the development of a layer of two allotropes of carbon in the form of a composite on SiC grain surface which is coherent with the surface and less prone to peel off because it grows from within the surface matrix by selective removal of Si atoms and rearrangement/epitaxy of C atoms.

In another aspect of the invention, said process results to get rid of the addition of impurities in the charge, kept within the crucible, from the anode during arc discharge process by introduction of crucible wall (base) as a barrier between the anode and the charge (SiC).

In another aspect of the invention, the indirect heating process by arc plasma where the plasma flame cannot interfere with the charge while undergoing physical or chemical processing within the crucible, thus facilitating epitaxial growth process on SiC grain surface for production of DLC phase.

The present invention provides a process for high temperature dissociation of SiC producing an *in situ* growth DLC + graphite composite on SiC grains by selected removal of Si from grain surface by indirect arc plasma heating of SiC grains placed inside a conducting ceramic crucible. The special arc configuration is shown in **Fig.1** Figure 1 represents schematic view of indirectly heated arc plasma reactor wherein
1- Anode
2- Cathode
3- Graphite crucible
4- Covering lid
5- Argon gas
6- Plasma flame
7- Exhaust gas and vapors

Graphite crucible is connected to negative polarity (cathode) and the graphite rod below the crucible is connected to positive polarity of electricity (anode). The cathode is in the form of a graphite crucible and the anode is a graphite rod placed below the crucible at a small distance which is maintained variable. Higher heat generation at cathode (due to ions hitting) compared to anode (where electrons used hit) results in generation of temperature as high as 2900-3100°C within few minutes that causes dissociation of SiC to produce the DLC + graphite composite coating.

SiC grains in the form of powder are kept inside the graphite crucible by opening its lid provided at the top. The lid was kept open and also partially closed during heat treatment. SiC powder of three different makes and of different grain sizes were used in the heat treatment. The plasma flame is formed in the arc zone by passing Ar or inert gas between the anode and cathode and the flame hits upon the crucible base and thus heats up the crucible from the bottom to produce a uniform heat treatment of the SiC grains placed inside the crucible.

The entire arc configuration including the crucible containing charge are placed inside a water cooled enclosure such as reactor or furnace which is provided with an exhaust system to continuously let out gases and vapours emanating from the reactor/furnace. The crucible is provided with a non-melting ceramic lid to open and close as per requirement. Voltage and current conditions in the dc arc plasma were maintained as follows: 50-70V, 400-550A. The length of arc in the plasma was maintained in the range 2-3 cm. Argon gas was used as the plasma forming gas and it was introduced into the arc zone at a rate of 3-15 lit per min through a central axial hole in the anode. Inert gas like N₂ or Ar at a rate of 2 lit per min was passed into the crucible space by a separate arrangement to prevent any oxidation in the charge as well as product. H₂ was also introduced with Ar/N₂ in the crucible at 1:1 to 1:3 ratio to observe their influence in the dissociation and coating growth and to reduce the occurrence of graphite phase in the carbonaceous composite coated on SiC grains.
The temperature of the graphite crucible was maintained at 2900-3100°C while heat treatment of the SiC powder/grains kept in the crucible was carried out for 15-30 min by the indirect arc plasma heating and then it was followed by switching off of the electrical power in the arc to cool off the reactor/furnace. Cooling of the reactor including SiC powder in graphite crucible was carried out until room temperature and it took around 4 hours to reach the room temperature. Inert gas or its mixture (Ar, Ar+N₂, Ar+H₂ and N₂+H₂) was circulated in the graphite crucible during arc plasma heating as well as during cooling cycle for 1 hour after power switch off. After cooling off, the SiC powder was removed from graphite crucible and was characterized by micro Raman spectra to identify the constituents present in the composite surface coating on SiC grains.
Micro Raman spectra showed peaks in the range 1335 - 1368 cm⁻¹ due to DLC and in the range 1569 - 1596 cm⁻¹ and 2677 - 2730 cm⁻¹ due to graphite. Recovery of the heat treated SiC powder was obtained up to 98 wt%. Si removal from surface of SiC grain by the thermal dissociation (heat treatment) was observed in the range 98-99 at%. Surface microhardness of the resulting carbonaceous composite layer (DLC + graphite) on SiC grain was determined and it exhibited upper range value between 1900 to 2600 VHN_{0.1}.
Heat treatment at 2900-3100°C causes dissociation of the carbide; selected removal of Si atoms in vapour form from the surface of SiC grains are sent out from furnace/reactor by an exhaust leaving behind the dissociated SiC grains and thus resulting in the growth of DLC + graphite composite in the form of coating/layer on SiC surface by rearrangement of some dissociated C atoms on underlying grain surface during cooling process below 2200°C leading to an epitaxial growth of these carbon on SiC (SiC has similar crystallographic structure as that of diamond) *in situ* in a diamond lattice (in the form of DLC).

### EXAMPLES

The following examples are given by way of illustration of the present invention and therefore should not be construed to limit the scope of the present invention.

### Example 1

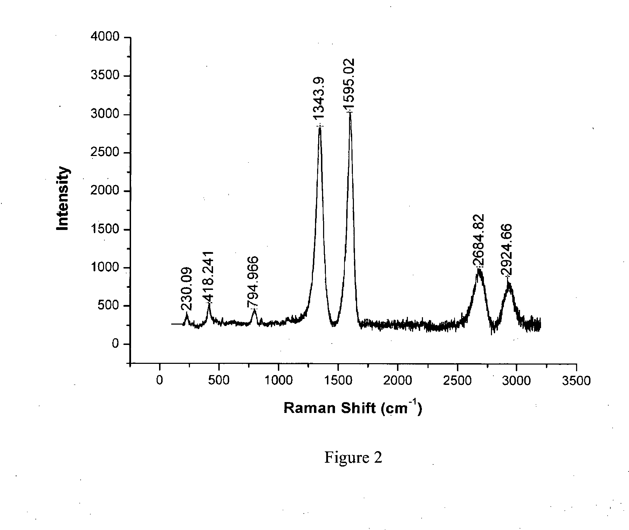

SiC powder in mixed phase (α +β) prepared from rice husk by carbothermic reduction in arc plasma (B. B. Nayak et al., J. Am. Ceram. Soc. Vol. 93, page 3080-3083, 2010) was used for high temperature dissociation by indirect arc plasma heating to produce composite coating of DLC and graphite. 10% of SiC grains in the powder were <10 µm and the rest were 10-163 µm size. In the beginning, 50g of SiC powder was kept in the graphite crucible with 6 cm inner diameter and 10 cm height (**Fig.1**). Thickness in the side wall as well as base of the crucible was around 1 cm. The crucible lid (1 cm thick) was partially closed on the top and Ar gas at the rate of 6 lit per min was allowed to pass in the arc zone. Inside the graphite crucible Ar was passed at the rate of 2 lit per min by a separate arrangement to prevent oxidation of charge as well as product. The entire arcing configuration and crucible (in the form of cathode) were kept in a water cooled enclosure (called reactor/furnace) with provision for exhaust at its top to expel gases and vapours produced during plasma heating. The arc was operated with the following conditions: arc length: 2 cm, voltage: 50-55 V dc, current: 500-550A, time duration of arcing: 15 min. To initiate heating, the arc was first started by switching on electric power to the arc while maintaining gas flows mentioned above. The plasma flame produced by the arc discharge between crucible base (cathode) and underneath graphite anode (circular rod) started heating the crucible at the base and nearby vicinity and thus SiC grains lying inside graphite crucible got heated up to reach a temperature of 2900 °C. The temperature of graphite crucible base was monitored by a two colour infrared pyrometer (accuracy: 0.5% of reading) focused at the crucible base region through a quartz port in reactor wall. Temperature of graphite crucible base was assumed to be equal to the temperature of SiC grains which were lying on the inner base of crucible. After 15 min the power in the arc was switched off and the reactor/furnace was cooled off for 4 hours and reached room temperature. Ar flow in the graphite crucible as well as arc zone was continued for 1 hour more after power switch off in order to prevent oxidation. During the heat treatment process, Si in the form of vapour was removed from SiC grain surface after dissociation above 2200°C (occurs till 2825° C, its dissociation temperature) and the left out C in the dissociated SiC matrix was left out. Since SiC has similar crystallographic structure as that of diamond, on the grain surface some of the left out C grew as DLC by epitaxial process and some were also left in graphite phase. The dissociated C thus makes a composite coating or layer of DLC + graphite on SiC grain surface by an in situ process. Micro Raman spectra of the heat dissociated SiC grains shown in **Fig.2** confirm the occurrence of intense DLC peak at 1343.9 cm⁻¹ and graphite peaks at 1595.02 cm⁻¹ (prominent) & 2684.82 cm⁻¹ (weak) due to G bands, 2924.66 cm⁻¹ (weak) due to sp²C cluster on the surface along with weak SiC peaks occurring at 794.966, 418.241 and 230.09 cm⁻¹ (due to underneath SiC grain on which composite layer has grown). Micro hardness measured on SiC grain surface coated with the composite (DLC + graphite) shows upper range value between 2120 to 2540 VHN _{0.1}.

### EXAMPLE 2

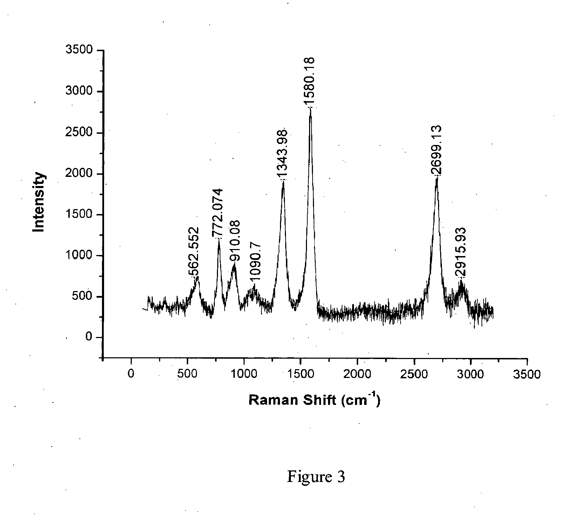

Aldrich make SiC powder (No. 409-21-2) in mixed phase (α+β) with 20-50 µm grain size was used for high temperature dissociation by indirect arc plasma heating to produce the DLC+ graphite composite. Heat treatment procedure adopted was similar to example 1 described above. Experimental conditions adopted here are as follows:
Wt. of SiC powder taken: 20 g
Rate of Ar (plasma forming gas) flow in arc: 7 lit per min
Gas passed in graphite crucible: Ar + H₂
Rate of flow of gas in graphite crucible: Ar at the rate of 3 lit per min,
   H₂ at the rate of 1 lit per min
Arc length: 2 cm, Arc conditions: voltage 55-65 V dc, current 500-550A
Time duration of SiC heat treatment in crucible: 15 min
Temperature of heat treatment: 2980°C
Micro Raman spectra characterization (**Fig.3**) of the composite coating on SiC grains show strong peaks at 1343.98 cm⁻¹ due to DLC, at 1580.18 and 2699.13 cm⁻¹ due to graphite (G band), weak peak at 2915.93 cm⁻¹ due to sp²C cluster besides other weak peaks at 562.552, 772.074 (SiC, TO mode), 910.08 (SiC, LO mode) and 1090.7 cm⁻¹. Micro hardness measured on SiC grain surface coated with the composite (DLC + graphite) shows upper range value between 2050 to 2370 VHN_{0.1}.

### EXAMPLE 3

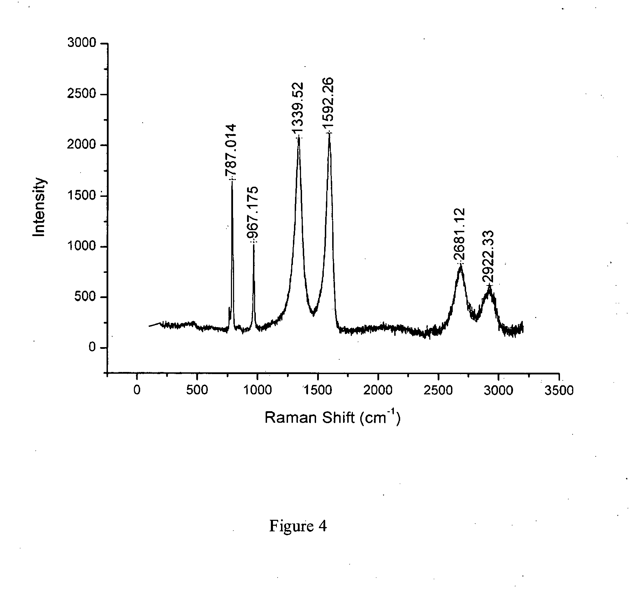

CUMI (Carborandum Universal) make SiC powder of 800 grit size (grain size 6.50 µm) underwent high temperature dissociation to grow DLC + graphite composite on SiC grains in the same way as described in example 1. The experimental conditions adopted are as follows:
Wt. of SiC powder taken: 20 g
Rate of Ar (plasma forming gas) flow in arc: 6 lit per min
Gas passed in graphite crucible: Ar
Rate of Ar flow in graphite crucible: 2 lit per min,
Arc length: 2 cm, Arc conditions: voltage 60-65 V dc, current 500-550A
Time duration of SiC heat treatment in crucible: 15 min
Temperature of heat treatment: 3030°C
Micro Raman spectra characterization (**Fig.4**) of the composite coating on SiC grains show strong peaks at 1339.52 cm⁻¹ due to DLC, at 1592.26 due to graphite, small peak at 2681.12 cm⁻¹ due to graphite, weak peak at 2922.33 cm⁻¹ due to sp²C cluster besides two other medium intensity peaks at 967.175 and 787.014 cm⁻¹ due to SiC. Micro hardness measured on SiC grain surface coated with the composite (DLC + graphite) shows upper range value between 2145 to 2570 VHN_{0.1}.

### EXAMPLE 4

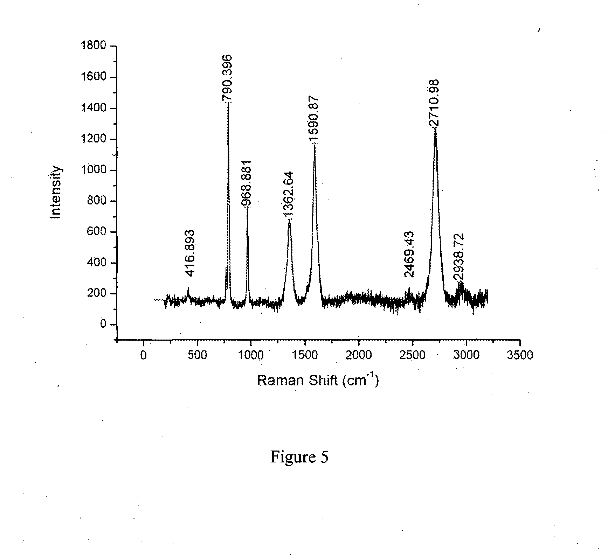

CUMI (Carborandum Universal) make SiC powder of 800 grit size (grain size 6.50 µm) underwent high temperature dissociation to grow DLC + graphite composite on SiC grains in the same way as described in example 3 but with change in gas conditions. The experimental conditions adopted are as follows:
Wt. of SiC powder taken: 20 g
Rate of Ar (plasma forming gas) flow in arc: 15 lit per min
Gas passed in graphite crucible: N₂ + H₂
Rate of gas flow in graphite crucible: 2 lit per min each for N₂ and H₂
Arc length: 2 cm, Arc conditions: voltage 60-65 V dc, current 520-550A
Time duration of SiC heat treatment in crucible: 15 min
Temperature of heat treatment: 3050°C
Micro Raman spectra characterization (**Fig.5**) of the composite coating on SiC grains show medium intensity peak at 1362.64 cm⁻¹ due to DLC, strong peaks at 1590.87 and 2710.98 cm⁻¹ due to graphite, weak peak at 2938.72 cm⁻¹ due to sp²C cluster besides two medium intensity peaks at 968.881 and 790.396 cm⁻¹ due to SiC. Micro hardness measured on SiC grain surface coated with the composite (DLC + graphite) shows upper range value between 1970 to 2245 VHN_{0.1}.

### ADVANTAGES OF THE INVENTION

### The main advantages of the present invention are:

➢ The process makes use of low cost arc plasma heating of graphite crucible where the crucible is used as cathode itself.
➢ Provides relatively harder composite coating (due to presence of DLC) with lubricating property (due to presence of graphite) prepared on SiC grain by heat treatment in an indirect arc plasma heated graphite crucible.
➢ The arc plasma heating process is an indirect heating process where plasma flame does not disturb any epitaxial growth of carbon on SiC and the process gets rid of impurities addition in charge/ product from anode during arc discharge.
➢ The indirect plasma heating process where plasma flame produced by arc discharge between anode and cathode hits upon the base of graphite crucible but not directly on SiC powder. Thus it promotes uniform/homogeneous heating of the crucible base, which in turn promotes uniform/homogeneous heating of SiC grains/powder.
➢ The process accepts SiC powders of all sizes, coarse, fine, ultrafine, nanocrystalline and also lumps to grow *in situ* a composite of DLC and graphite on SiC grains.
➢ The process adopts high temperature dissociation of the carbide compound and then utilizes epitaxial growth of C on SiC during cooling cycle (below 2200°C and up to room temperature), thus it is a process which can be applicable to all kinds of compounds which do not undergo melting and directly go from solid state to vapour state by dissociation process, including carbides, to selectively remove some constituent elements and develop coherent coatings of left out elements in matrix or their composites on grain surfaces.
➢ The process cuts down time from hours to days (in conventional dissociation process) to not more than 15-30 min for depositing the harder but lubricating coating on SiC.
➢ The process does not involve any sophistication like high vacuum, ion sputtering, etc., hence dispenses with high investment for production of hard but lubricating coating. It has therefore a good scope for scaling up to industrial scale.
➢ The process is relatively non-polluting as inert gas or/and nitrogen and hydrogen are used in plasma forming and within the crucible respectively.
➢ The process does not use any hydrocarbon, in solid, liquid or gaseous form, and also able to produce the DLC+ graphite coating with/ without use of H₂ in crucible during growth process.
➢ The process does not involve any chemical reaction involving corrosive and toxic ions like halogen and offers a clean method to prepare DLC and graphite coating for wear resistant lubricating application.
➢ The process utilizes the advantage of low boiling point of Si (2680°C) compared to complete dissociation temperature of SiC (2825°C) and very high melting point (∼3800°C) and boiling point (∼4800°C) of C, thus making it feasible to selectively remove Si at the processing temperature range (2900-3100°C) and produce epitaxial arrangement of dissociated C resulting in DLC + graphite composite growth on the surface of underlying SiC grain during cooling cycle which reaches up to room temperature.
➢ The process provides a method that involves rearrangement / epitaxy of dissociated C atoms on SiC surface during cooling cycle wherein it develops coating of DLC + graphite from within matrix, thus the bonding of layer with the matrix is coherent and stronger, thereby making the layer difficult to peel off from SiC surface.

## Claims

1. A process for in situ growth of carbonaceous composite coating of diamond like carbon (DLC) and graphite on silicon carbide (SiC) grains by carrying out thermal dissociation of SiC by an indirect arc plasma heating and the said process comprising the steps of:
i. providing SiC grains in a graphite crucible;
ii. passing inert gas in the arc zone situated below the graphite crucible at the rate of 3 to 15 litre per minute to produce high temperature in the range of 2900 to 3100°C;
iii. passing an inert gas inside the graphite crucible at the rate of 1 to 3 litre per minute;
iv. heating the graphite crucible by arc plasma for a period in the range of 15 to 30 minutes, maintaining arc length in the range of 1 to 3 cm, voltage in the range of 50 to 70 V and current in the range of 400 to 550A;
v. continuing the inert gas flow in arc zone and in graphite crucible for 50 to 70 minutes;
vi. cooling the reactor for a period in the range of 3 to 5 hours until temperature reaches in the range of 25 to 30°C to obtain a carbonaceous composite coating having diamond like carbon (DLC) and graphite on silicon carbide (SiC) grains.

2. The process as claimed in claim 1, wherein in step (ii) inert gas in the arc zone is passed through a central axial hole in the graphite anode.

3. The process as claimed in claim 1, wherein SiC grains used are selected from the group consisting of coarse, fine, ultrafine, nanocrystalline or lumps or combination thereof

4. The process as claimed in claim 1, wherein inert gas used in step (ii) is argon.

5. The process as claimed in claim 1, wherein inert gas used in step (iii) is selected from the group consisting of Ar, N₂ or their mixture with H₂ in the ratio ranging between 1:1 to 1:3.

## Patentansprüche

1. Verfahren für das In-situ-Wachstum einer kohlenstoffhaltigen Komposit-Beschichtung aus diamantartigen Kohlenstoff (DLC) und Graphit auf Siliziumcarbid (SiC) -Körnern, indem eine thermische Dissoziation von SiC durch eine indirekte Lichtbogenplasmaerwärmung durchgeführt wird und wobei das Verfahren die Schritte umfasst:
i. Bereitstellen von SiC-Körnern in einem Graphittiegel;
ii. Einleiten von Inertgas in die Lichtbogenzone, die unter dem Graphittiegel lokalisiert ist, mit einer Menge von 3 bis 15 Litern pro Minute, um eine hohe Temperatur in dem Bereich von 2900 bis 3100 °C herzustellen;
iii. Einleiten von Inertgas in den Graphittiegel hinein mit einer Menge von 1 bis 3 Litern pro Minute;
iv. Erwärmen des Graphittiegels durch das Lichtbogenplasma für einen Zeitraum in dem Bereich von 15 bis 30 Minuten, wobei die Lichtbogenlänge in dem Bereich von 1 bis 3 cm, die Spannung in dem Bereich von 50 bis 70 V und der Stromstärke in dem Bereich von 400 bis 550 A aufrechterhalten wird;
v. Fortsetzen des Inertgasflusses in die Lichtbogenzone und in den Graphittiegel für 50 bis 70 Minuten;
vi. Kühlen des Reaktors für einen Zeitraum in dem Bereich von 3 bis 5 Stunden bis die Temperatur einen Beriech von 25 bis 30 °C erreicht, um eine kohlenstoffhaltige Komposit-Beschichtung zu erhalten, die diamantartigen Kohlenstoff (DLC) und Graphit auf Siliziumcarbid (SiC) -Körnern aufweist.

2. Verfahren nach Anspruch 1, wobei in dem Schritt (ii) Inertgas durch ein zentrales, axiales Loch in der Graphitanode in die Lichtbogenzone eingeleitet wird.

3. Verfahren nach Anspruch 1, wobei die verwendeten SiC-Körner aus einer Gruppe ausgewählt sind, die aus groben, feinen, ultrafeinen, nanokristallinen Körnern oder aus Klumpen oder Kombinationen davon besteht.

4. Verfahren nach Anspruch 1, wobei das Inertgas, das in dem Schritt (ii) verwendet wird, Argon ist.

5. Verfahren nach Anspruch 1, wobei das Intertgas, das in dem Schritt (iii) verwendet wird, aus der Gruppe ausgewählt ist, die aus Ar, N₂ oder ihren Mischungen mit H₂ in dem Verhältnis, das sich zwischen 1:1 bis 1:3 erstreckt, besteht.

## Revendications

1. Procédé de croissance in situ d'un revêtement composite carboné de carbone de type diamant (DLC : diamond like carbon) et de graphite sur des grains de carbure de silicium (SiC) en réalisant une dissociation thermique du SiC par un chauffage par plasma d'arc indirect et ledit procédé comprenant les étapes consistant à :
i. utiliser des grains de SiC dans un creuset en graphite ;
ii. faire passer un gaz inerte dans la zone de l'arc située au-dessous du creuset en graphite à la vitesse de 3 à 15 litres par minute pour produire une température élevée comprise dans la plage allant de 2 900 à 3 100 °C;
iii. faire passer un gaz inerte à l'intérieur du creuset en graphite à la vitesse de 1 à 3 litres par minute ;
iv. chauffer le creuset en graphite par plasma d'arc pendant une période comprise dans la plage allant de 15 à 30 minutes, en maintenant la longueur de l'arc dans la plage allant de 1 à 3 cm, la tension dans la plage de 50 à 70 V et le courant dans la plage de 400 à 550 A ;
v. poursuivre le flux de gaz inerte dans la zone de l'arc et dans le creuset en graphite pendant 50 à 70 minutes ;
vi. refroidir le réacteur pendant une période comprise dans la plage allant de 3 à 5 heures jusqu'à ce que la température atteigne la plage de 25 à 30 °C pour obtenir un revêtement composite carboné comprenant du carbone de type diamant (DLC) et du graphite sur des grains de carbure de silicium (SiC).

2. Procédé selon la revendication 1, dans lequel dans l'étape (ii), le gaz inerte dans la zone de l'arc passe par un trou axial central dans l'anode de graphite.

3. Procédé selon la revendication 1, dans lequel les grains de SiC utilisés sont choisis dans le groupe constitué par les grains grossiers, fins, ultrafins, nanocristallins ou des agglomérats ou des combinaisons de ceux-ci.

4. Procédé selon la revendication 1, dans lequel le gaz inerte utilisé dans l'étape (ii) est l'argon.

5. Procédé selon la revendication 1, dans lequel le gaz inerte utilisé dans l'étape (iii) est choisi dans le groupe constitué par Ar, N₂ ou leur mélange avec H₂ selon un rapport compris dans la plage allant de 1:1 à 1:3.
